## Europäisches Patentamt

(19) **European Patent Office** —

Office européen des brevets

(11) Numéro de publication: **0 240 400**
**B1**

---

(12) **FASCICULE DE BREVET EUROPEEN**

(45) Date de publication du fascicule du brevet:
24.10.90

(51) Int. Cl.⁵: **G02B 6/10, H01S 3/19,**
**H01L 33/00**

(21) Numéro de dépôt: 87400622.4

(22) Date de dépôt: **19.03.87**

(54) Guide d'onde optique en matériau semiconducteur, laser appliquant ce guide d'onde et procédé de réalisation.

---

(30) Priorité: 28.03.86 FR 8604523

(43) Date de publication de la demande:
07.10.87 Bulletin 87/41

(45) Mention de la délivrance du brevet:
24.10.90 Bulletin 90/43

(84) Etats contractants désignés:
**DE GB IT NL**

(56) Documents cités:
EP-A- 0 002 827
EP-A- 0 081 956
EP-A- 0 114 109
EP-A- 0 166 593

ELECTRONICS LETTERS,
vol. 20, no. 21, 11 octobre 1984, pages 850-851, Londres, GB; R. BLONDEAU et al.: "CW operation of GaInAsP buried ridge structure laser at 1.5 mum grown by LP-MOCVD"
OPTICS COMMUNICATIONS,
vol. 56, no. 4, 15 décembre 1985, pages 235-239, Elsevier Science Publishers B.V., Amsterdam, NL; S. OHKE et al.: "Optical waveguides using GaAs-A1xGa1-xAs multiple quantum well"
JOURNAL OF APPLIED PHYSICS,

(73) Titulaire: THOMSON-CSF, 51, Esplanade du Général de Gaulle, F-92800 Puteaux(FR)

(72) Inventeur: Blondeau, Robert,
Thomson-CSF§SCPI§19, avenue de Messine,
F-75008 Paris(FR)
Inventeur: Bourbin, Yannic,
Thomson-CSF§SCPI§19, avenue de Messine,
F-75008 Paris(FR)
Inventeur: De Cremoux, Baudouin,
Thomson-CSF§SCPI§19, avenue de Messine,
F-75008 Paris(FR)
Inventeur: Papuchon, Michel,
Thomson-CSF§SCPI§19, avenue de Messine,
F-75008 Paris(FR)
Inventeur: Krakowski, Michel,
Thomson-CSF§SCPI§19, avenue de Messine,
F-75008 Paris(FR)
Inventeur: Razeghi, Manijeh,
Thomson-CSF§SCPI§19, avenue de Messine,
F-75008 Paris(FR)
Inventeur: Lozes, Françoise,
Thomson-CSF§SCPI§19, avenue de Messine,
F-75008 Paris(FR)
Inventeur: Bensoussan, Alain,
Thomson-CSF§SCPI§19, avenue de Messine,
F-75008 Paris(FR)

(74) Mandataire: Lepercque, Jean et al, THOMSON-CSF SCPI, F-92045 PARIS LA DEFENSE CEDEX 67(FR)

(56) Documents cités: (suite)
vol. 56, no. 9, 1 novembre 1984, pages 2595-2598, American Institute of Physics, New York, US; K. OKAMOTO et al.: "InGaAsP double-heterostructure optical waveguides with p+-n junction and their electroabsorption"

---

ACTORUM AG

## Description

La présente invention concerne un guide d'onde optique en matériau semiconducteur, un laser appliquant ce guide d'onde et un procédé de réalisation.

Les matériaux semiconducteurs ont suscité un intérêt croissant au cours des quinze dernières années pour leurs propriétés remarquables dans les télécommunications optiques comme sources et détecteurs de lumière dans le domaine spectral du proche infrarouge en particulier là où les fibres optiques de silice présentent des atténuations et dispersions très faibles. Parallèlement aux études visant à rendre ces composants d'extrémité que sont diodes lasers et photodiodes plus fiables et performants, la possibilité de mieux traiter l'information grâce à l'optique intégrée se faisait jour. Tout d'abord, sur substrats passifs (verre) puis actifs (niobate ou tantalate de lithium), des composants modulateurs de phase ou d'amplitude, translateurs de fréquence ou commutateurs de lumière en milieu guidé ont été réalisés et ont démontré le nouveau potentiel d'un traitement sous forme optique de l'information. Ce n'est que récemment que les recherches en optique intégrée sur matériaux semiconducteurs III.V notamment laissent envisager l'intégration sur un même substrat de sources, détecteurs, composants modulateurs et commutateurs.

Dans le domaine des diodes lasers, une nécessité est d'obtenir des diodes lasers bien contrôlées et des diodes lasers de puissance, voire même des diodes lasers en réseau. Pour cela, la base d'une diode laser résidant dans un guide d'onde, l'objectif doit donc être d'optimiser ce guide d'onde pour obtenir une plus grande précision et de plus grandes puissances.

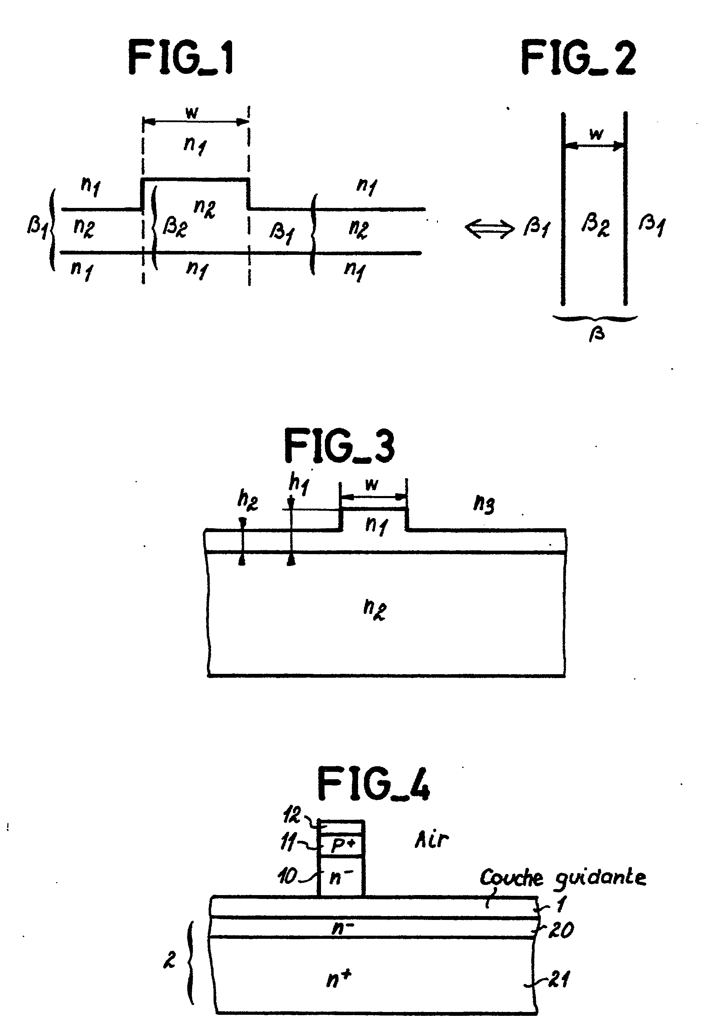

Il est par conséquent tout à fait nécessaire de disposer de guides d'ondes à très faibles pertes dans les matériaux semiconducteurs III-V réalisables de façon compatible avec la technologie actuellement au point pour les diodes lasers. On tirera par conséquent le profit maximum de nouvelles techniques d'épitaxie et d'attaque chimique sélective de couches minces ou ultra minces (plusieurs dizaines d'Angströms dans le cas des puits quantiques). On utilisera par exemple, la technique d'épitaxie d'organométalliques en phase vapeur à pression réduite, désignée en terminologie anglosaxonne par LP MOCVD (Low Pressure Metallorganic Chemical Vapor Deposition), ou d'épitaxie par jets moléculaires (MBE). Pour comprendre le processus de guidage dans des dispositifs à semiconducteurs on peut utiliser parmi d'autres méthodes, les méthodes des indices effectifs qu'on rappelle brièvement ci-après. La structure guidante représentée en figure 1 peut être découpée en trois guides plans juxtaposés définis chacun par un jeu de paramètres optogéométriques. Il est alors possible analytiquement de trouver les constantes de propagation de chacun des guides plans pris séparément lorsqu'ils sont formés de milieux d'indices constants $n_i$, ce qui sera toujours le cas pour les structures couramment envisagées. Ces constantes de propagation $\beta_i$ peuvent se concevoir comme des indices de réfraction d'un autre guide plan dont on peut aussi calculer la constante de propagation $\beta$. La méthode de l'indice effectif consiste à considérer $\beta$ comme la constante de propagation de la structure de départ. Cette méthode trouve une interprétation physique en théorie des rayons lorsque ces derniers se réfléchissent à la frontière de milieux d'indices différents. Tout se passe donc comme si la lumière était confinée par un milieu d'indice $\beta_2$ de largeur w entouré par des milieux semi infinis d'indice $\beta_1$ comme cela est représenté en figure 2.

Les structures les plus simples qui ont permis d'obtenir les premiers guides dans les matériaux semiconducteurs ont été constitués par le dépôt d'une couche mince de guidage faiblement dopée sur un substrat de quelques centaines de microns d'épaisseur considéré comme infini aux longueurs d'ondes de l'infrarouge utilisées. Une telle structure est représentée en figure 3, avec la couche de guidage référencée 1 et le substrat référencé 2. Dans ce cas, la structure est entourée par une couche de confinement optique supérieure qui est généralement de l'air (avec un indice n = 1) et l'on ajuste les paramètres w, h1, h2 connaissant les indices de réfraction n1 de la couche de guidage et n2 du substrat pour obtenir le guidage par indice effectif souhaité. Ces structures présentent en général des pertes non négligeables parce que la diffraction par les irrégularités des flancs verticaux du guide peut y être importante selon le type d'attaque d'une part et d'autre part, parce que l'on utilise souvent des substrats dopés qui permettent d'appliquer un champ électrique de commande au voisinage du guide. Les porteurs libres que l'on y rencontre sont responsables de l'atténuation de la partie évanescente de l'onde guidée par ces milieux diélectriques.

Le document EP-A 0 002 827 constitue un exemple de l'état de la technique.

Des structures plus élaborées ont alors été conçues et réalisées. Elles comportent des couches tampon d'isolement optique du guide des milieux à fort dopage. La structure de type nervure est alors réalisée par l'attaque chimique sélective de la couche tampon supérieure avec arrêt sur le matériau de la couche guidante. On trouve un exemple d'une telle structure en figure 4. Cette structure comporte un substrat 21 portant une couche tampon (20) dopée $\bar{n}$, laquelle porte une couche de guidage optique 1 complétée par des éléments de guidage 10 et 11 dopés respectivement $\bar{n}$ et p+, et qui excités par un champ électrique appliqué à une électrode métallique 12 permet une modulation de phase d'une onde lumineuse par effet électrooptique.

A titre d'exemple, le substrat 21 et la couche tampon 20 peuvent être en phosphure d'indium (InP). La couche guidante et les éléments de guidage peuvent être en Arséniure de Gallium et d'Indium (GaInAs) ou en phosphure d'Arséniure de Gallium et d'Indium (Ga In As P).

Potentiellement meilleure, cette structure permet difficilement d'atteindre des pertes inférieures à 1 ou 2 dB/cm dans InP/InGaAsP à $\lambda$ = 1.55 $\mu$m. Si le matériau de confinement supérieur de la structure est constitué par de l'air, le guidage par indice effectif est fort et cela peut poser un problème si l'on veut réaliser un coupleur directionnel car on est alors amené à rapprocher les guides nervures à des distances parfois inférieures au micron. Pour diminuer le guidage par indice effectif, on peut laisser une partie de la couche tampon supérieure, mais celle-ci est généralement de l'ordre du micron d'épaisseur et il est très difficile technologiquement d'obtenir des états de surface minimisant les pertes par diffusion. Par ailleurs, on perd le bénéfice de la propriété des états de surface que l'on obtient en attaque chimique sélective par l'arrêt sur une couche épitaxiée par méthode d'épitaxie en phase vapeur (MOCVD) d'excellente qualité optique.

C'est pourquoi l'invention concerne une structure de guide réalisable par l'association du procédé d'épitaxie en phase vapeur et du procédé d'attaque chimique sélective.

Le procédé d'épitaxie en phase vapeur permet d'obtenir des couches ultra minces permettant de diminuer à volonté le guidage par indice effectif. Le procédé d'attaque chimique sélective permet d'usiner des motifs sur une couche sans modifier les autres.

La structure alors obtenue est réalisée avec une grande précision d'une part dans l'épaisseur des couches d'autre part dans la géométrie de ces éléments et elle permet par ailleurs d'obtenir une excellente qualité de surface.

L'invention concerne un guide d'onde optique intégré en matériau semiconducteur comprenant au moins une couche d'un matériau de guidage optique d'un premier indice recouvrant au moins une couche de confinement optique inférieure, d'un deuxième indice, au moins un élément de guidage optique en forme de ruban de largeur déterminée, s'étendant au dessus de ladite couche de guidage optique dans la direction de propagation du guide, ledit ruban de guidage ayant un quatrième indice et au moins une couche de confinement optique supérieure, d'un troisième indice, recouvrant ledit ruban de guidage tout en s'étendant de part et d'autre de celui-ci au dessus de ladite couche de guidage, le premier indice étant supérieur au deuxième indice et au troisième indice et le quatrième indice étant également supérieur au troisième indice, ledit guide d'onde étant caractérisé en ce qu'il comporte en outre au moins une couche d'arrêt d'attaque chimique interposée entre ladite couche de guidage d'une part, et ledit ruban de guidage et ladite couche de confinement supérieure d'autre part l'ensemble étant agencé de sorte que ledit ruban de guidage repose sur ladite couche d'arrêt d'attaque chimique cependant que ladite couche de confinement supérieure recouvre ledit ruban ainsi que ladite couche d'arrêt, le matériau de cette couche d'arrê-td 'attaque chimique étant de nature chimique différente de celui dudit ruban et l'épaisseur de cette couche d'arrêt d'attaque chimique étant choisie suffisamment faible pour ne pas nuire sensiblement aux qualités optiques dudit guide d'onde.

L'invention concerne également un laser à semiconducteur comprenant le guide d'onde selon l'une quelconque des revendications précédentes, selon lequel:

– ladite couche de confinement optique inférieure comprend un substrat en un matériau semiconducteur dopé d'un type déterminé, de paramètre de maille et de largeur de bande interdite déterminées;

– ladite couche de guidage optique servant de zone active est en un matériau semiconducteur de paramètre de maille adapté à un multiple ou sous-multiple de celui de la couche de confinement optique inférieure et de largeur de bande interdite inférieure à celle de la couche de confinement optique inférieure;

– l'adite couche d'arrêt d'attaque chimique (4) a un paramètre de maille adapté à un multiple ou sous-multiple de celui de la couche de guidage optique (1);

– ladite couche de confinement optique supérieure est en un matériau semiconducteur dopé de type contraire à celui de la couche de confinement optique inférieure et de paramètre de maille adapté à celui de la couche d'arrêt d'attaque chimique et de largeur de bande interdite supérieure à celle de la couche de guidage optique et de l'élément de guidage optique;

– et selon lequel au moins deux électrodes conductrices sont appliquées au guide d'onde.

Enfin, l'invention concerne un procédé de réalisation d'un guide d'onde en matériaux semiconducteurs ou d'un laser semiconducteur utilisant un tel guide d'onde, comportant les étapes suivantes:

a) une première étape de réalisation sur un substrat en matériau semiconducteur et recouvert d'une couche de confinement optique, d'une couche d'un matériau de guidage optique dont le paramètre de maille est adapté à celui du matériau de la couche de confinement optique et dont la largeur de bande interdite est inférieure à celle du matériau de la couche de confinement;

b) une deuxième étape de réalisation sur la couche de guidage optique d'une couche d'arrêt d'attaque chimique en matériau dont le paramètre de maille est adapté à celui du matériau de la couche de guidage optique;

c) une troisième étape de réalisation sur la couche d'arrêt d'attaque chimique d'une couche d'un matériau de guidage optique dont le paramètre de maille est adapté à celui du matériau de la couche d'arrêt d'attaque chimique;

d) une quatrième étape d'attaque chimique de la couche de matériau de guidage optique à l'aide d'un produit n'ayant aucune action sur la couche d'arrêt d'attaque chimique, de façon à réaliser au moins un élément de guidage optique en forme de ruban de largeur déterminée;

e) une cinquième étape de réalisation sur le ruban et sur la couche d'arrêt d'attaque chimique non couverte par ce ruban, d'une couche de confinement optique supérieure en un matériau semiconducteur de paramètre de maille adapté à ceux de l'élément de guidage optique et de la couche d'arrêt d'attaque chimique et de largeur de bande d'énergie supérieure à celle de l'élément de guidage optique et de la couche de guidage optique.

Les différents objets et caractéristiques de l'invention apparaîtront plus clairement dans la description qui va suivre, fait en se reportant aux figures annexées qui représentent :

- les figures 1 et 2, des schémas explicatifs de guides d'ondes connus dans la technique ;
- la figure 3, un exemple de réalisation d'une structure de guide d'onde à nervure connue dans la technique ;
- la figure 4, un exemple de réalisation d'un modulateur de phase à semiconducteurs fonctionnant par électrooptique connu dans la technique ;
- la figure 5, un exemple de réalisation d'un guide d'onde à semiconducteurs selon l'invention ;
- la figure 6, une vue en perspective du guide d'onde à semiconducteur de la figure 5 ;
- la figure 7, une variante de réalisation du guide d'onde à semiconducteurs de la figure 5 ;
- la figure 8, une autre variante de réalisation du guide d'onde à semiconducteurs dans laquelle l'élément de guidage optique comporte plusieurs couches ;
- la figure 9, un exemple de réalisation d'un modulateur de phase à semiconducteur appliquant le guide d'onde de l'invention ;
- les figures 10 à 15 différentes étapes d'un exemple du procédé de réalisation de l'invention ;
- les figures 16 et 17, un exemple du procédé de l'invention permettant d'obtenir le guide d'onde de la figure 8 ;
- la figure 18, un exemple de réalisation d'un laser à semiconducteur, selon l'invention ;
- la figure 19, un exemple de réalisation d'un réseau de guides d'onde ou de lasers couplés selon l'invention.

Des guides d'ondes réalisés sous forme de nervures usinées dans une couche guide d'onde existent dans la technique et ont été décrits précédemment en se reportant aux figures 1 à 4. Cependant ces guides d'ondes ne peuvent pas être réalisés avec précision et avec la qualité nécessaire à l'obtention d'un guide d'onde présentant des pertes à la propagation suffisamment faibles.

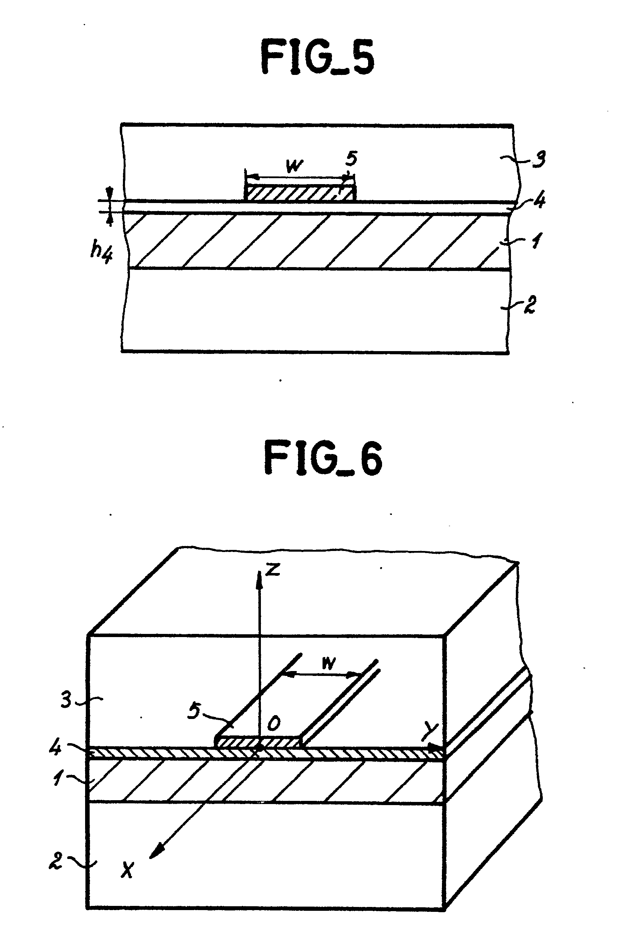

En se reportant à la figure 5, on va donc décrire un exemple de réalisation d'un guide d'onde permettant de pallier ces difficultés.

Cette structure de guide d'onde comporte :
- une couche de confinement optique inférieure 2 ;
- une couche de guidage optique 1 ;
- une couche d'arrêt d'attaque chimique 4 ;
- un élément de guidage optique 5 ;
- une couche de confinement optique supérieure 3 .

L'indice de réfraction n1 de la couche de guidage optique 1 est supérieur à l'indice de réfraction n2 de la couche de confinement optique inférieure 2. Il est également supérieur à l'indice n3 de la couche de confinement optique supérieure 3. L'indice de réfraction n5 de l'élément de guidage est supérieur à l'indice n3 de la couche de confinement optique supérieure 3.

Dans ces conditions, si on considère les largeurs de bandes d'énergie, la largueur de bande d'énergie d'un matériau étant inversement proportionnel à son indice de réfraction, les largeurs de bande d'énergie E2 et E3 des matériaux des couches de confinement optique inférieure et supérieure sont chacune supérieures à la largeur de bande d'énergie E1 de la couche de guidage optique 1 ainsi qu'à la largeur de bande d'énergie E5 de l'élément de guidage optique.

La couche d'arrêt d'attaque chimique 4 est de nature chimique différente de l'élément de guidage optique 5 de façon à ce que celui-ci puisse être attaqué par des agents chimiques qui n'attaquent pas la couche d'arrêt d'attaque chimique.

L'épaisseur de la couche d'arrêt d'attaque chimique 4 a une épaisseur négligeable comparée à la longueur d'onde de fonctionnement du guide d'onde, laquelle longueur d'onde est déterminée par la nature du matériau constituant la couche de guidage optique 1.

A titre d'exemple, l'épaisseur h4 de la couche d'arrêt d'attaque chimique sera comprise entre un dixième et un centième de la longueur d'onde d'utilisation. Dans ces conditions, la présence de la couche d'arrêt d'attaque chimique ne nuit pas sensiblement aux qualités optiques de la structure.

Une réalisation avec une épaisseur de 100 Angstroems de couche d'arrêt d'attaque chimique dans un guide d'onde fonctionnant à une longueur d'onde de 1,55 $\mu$m a donné de bons résultats.

Le guidage par indice effectif dans la structure de la figure 5 est très faible, de l'ordre de $10^{-4}$ par exemple. L'élément de guidage optique 5 peut alors avoir une largeur w plus importante que dans les techniques connues. L'influence des imperfections des flancs de l'élément 5 et notamment la rugosité des flancs perd donc de l'importance, d'autant plus que l'épaisseur de l'élément de guidage optique est faible.

La largeur w de l'élément de guidage optique 5 est donc fonction de son épaisseur et elle prend une valeur maximale selon que le guide est monomode transverse ou non. Il est également possible avec des va-

4

leurs différentes de w d'obtenir, par exemple, un guide bimode. Des exemples de valeurs numériques seront données ultérieurement.

Les pertes de propagation dans un tel guide d'ondes ne peuvent donc pratiquement être dues qu'à des imperfections d'états de surface des couches. Or, le procédé de réalisation qui sera décrit ultérieurement permet d'obtenir des états de surface de couches conduisant à des pertes négligeables.

La figure 6 représente en perspective le guide d'onde de la figure 5 avec l'élément de guidage optique 5 placé selon un plan xOy. La couche de confinement optique inférieure 2, la couche de guidage optique et la couche d'arrêt d'attaque chimique 4 sont parallèles au plan xOy et leurs dimensions selon les directions dans ce plan ne sont pas forcément limitées. L'élément de guidage 5 a la forme d'un ruban orienté selon l'axe Ox et permet une propagation lumineuse selon l'axe Ox. La couche de confinement optique supérieure 3 recouvre la couche d'arrêt d'attaque chimique 4 et l'élément 5.

La couche de guidage optique 1 est en matériau dont le paramètre de maille est adapté à un multiple ou à un sous-multiple de la couche de confinement optique inférieure 2. La couche d'arrêt d'attaque chimique 4 est en matériau dont le paramètre de maille est adapté à un multiple ou à un sous-multiple de la couche de guidage 1.

De même, les paramètres de maille de la couche de confinement optique supérieure 3 et de l'élément de guidage optique 5 sont adaptés entre eux et sont adaptés à celui de la couche d'arrêt d'attaque chimique 4.

Compte-tenu des caractéristiques techniques mentionnées précédemment (indices de réfraction, largeurs de bande interdite, paramètres de maille), les matériaux utilisés pour un guide d'onde ainsi décrit peuvent être réalisés par exemple à l'aide de composés de semiconducteurs des groupes III et V de la classification périodique des éléments.

Pour des questions de facilités de fabrication, les couches de confinement optique inférieure 2 et supérieure 3 ainsi que la couche d'arrêt d'attaque chimique 4 pourraient avoir la même largeur de bande d'énergie ($E2 = E3 = E4$) et être réalisées à l'aide d'un même matériau. De même, la couche de guidage optique 1 et l'élément de guidage optique 5 pourront également avoir la même largeur de bande d'énergie ($E1 = E5$) et être réalisés eux aussi à l'aide d'un même matériau.

Par exemple, les couches de confinement optique 2 et 3 et la couche d'arrêt d'attaque chimique peuvent être un phosphure d'indium InP tandis que la couche de guidage optique 1 et l'élément de guidage 5 peuvent être en Arséniure de Gallium et d'indium (Ga In As) ou en phosphure d'arséniure de Gallium et d'indium (Ga In As P).

Un guide optique en phosphure d'arséniure de gallium et d'indium fonctionne à des longueurs d'ondes d'environ 1,5 µm. Avec un tel matériau pour la couche de guidage optique 1 et l'élément de guidage 5, l'épaisseur (e4) de la couche d'arrêt d'attaque chimique pourra être avantageusement de l'ordre de 100 Angströms, ce qui lui permettra de ne pas avoir d'effet néfaste sur les qualités de transmission du guide d'onde.

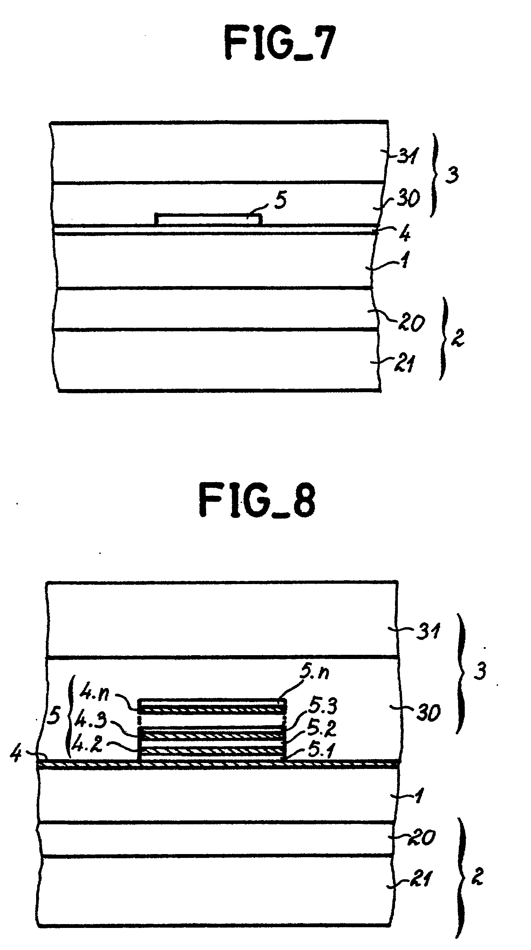

Selon l'exemple de réalisation de la figure 7, la structure des figures 5 et 6, prévoit un dopage pour la couche de confinement optique inférieure 2, une couche 21 dopée n+ et une couche 20 dopée n⁻ en contact avec la couche de guidage optique 1. La couche de confinement optique supérieure comporte également deux couches dopées = une couche 31 dopée p+ et une couche 30 dopée n⁻ en contact avec l'élément de guidage optique 5 et la couche d'arrêt d'attaque chimique 5. Les couches 20 et 30 constituent des couches tampon.

En se reportant à la figure 8, on va maintenant décrire une variante de réalisation du guide d'onde de l'invention. On retrouve sur cette figure 8 les différentes couches de la figure 7. Cependant l'élément de guidage optique 5 est réalisé différemment. En effet, il comporte plusieurs sous-couches. Sur la couche d'arrêt d'attaque chimique 4, il comporte une sous-couche 5.1 en matériau de guidage optique, puis une sous-couche d'arrêt d'attaque chimique 4.2. Ces sous-couches sont elles-mêmes recouvertes par une alternance de sous-couches en matériau de guidage optique 5.2 à 5.n et de sous-couches d'arrêt d'attaque chimique 4.3 à 4.n. Ces différentes sous-couches sont en matériaux dont le paramètre de maille est adapté aux paramètres de maille des sous-couches voisines et, pour les sous-couches d'extrémités 5.1 et 5.n, adaptées au matériau de la couche d'arrêt d'attaque chimique 4 (pour la sous-couche 5.1) et au matériau de la couche de confinement optique supérieure 3 (pour la sous-couche 5.n).

Les indices de réfraction des sous-couches d'arrêt d'attaque chimique 4.2 à 4.n et les indices de réfraction des sous-couches de guidage optique 5.1 à 5.n sont tels qu'un guidage par indice effectif soit réalisé dans la structure représentée en figure 8.

Pour des questions de facilités de fabrication, les sous-couches d'arrêt d'attaque chimique 4.2 à 4.n pourront être réalisées avec le même matériau que la couche d'arrêt d'attaque chimique 4. De même, les sous-couches de guidage optique 5.1 à 5.n pourront être le même que celui utilisé dans la description qui précède pour la couche de guidage optique 5.

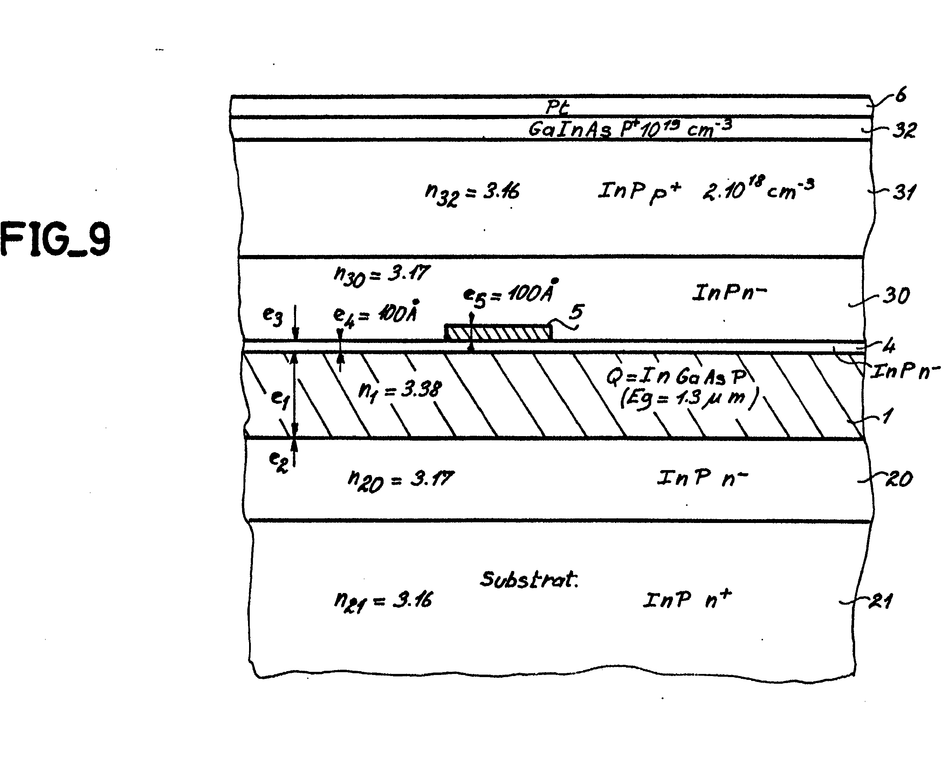

En se reportant à la figure 9, on va maintenant décrire un modulateur de phase appliquant le guide d'onde selon l'invention.

On retrouve sur cette figure, les couches de confinement optique inférieure 20 et 21 respectivement dopée n⁻ et n+, la couche de guidage optique 1, la couche d'arrêt d'attaque chimique 4, l'élément de guidage optique 5 et les couches de confinement optique supérieures 30 et 31 respectivement dopée n⁻ et p+.

A la partie supérieure de la couche de confinement 31, on trouve, par surcroit, une électrode métallique 6 permettant d'appliquer un champ électrique et d'obtenir ainsi un déphasage.

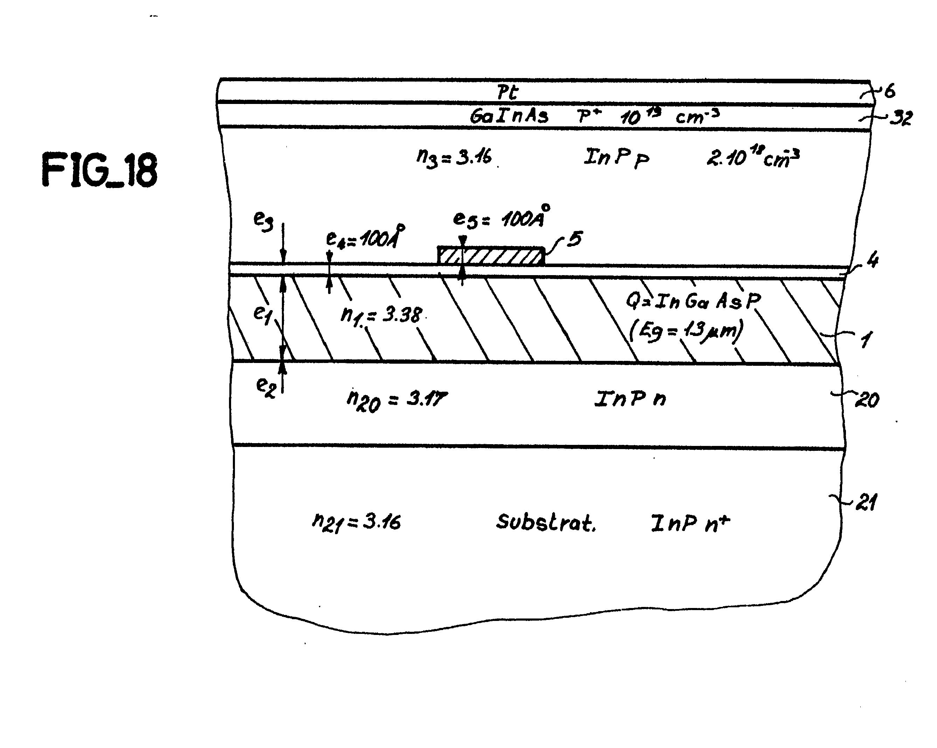

En se reportant à la figure 18, on va maintenant décrire un laser semiconducteur mettant en oeuvre une structure de guide d'onde similaire à celle décrite précédemment.

On trouve sur cette figure, les couches de confinement optique inférieure 20 et 21 respectivement dopée n+ et n, la couche de guidage optique 1, la couche d'arrêt d'attaque chimique 4, l'élément de guidage optique 5, et la couche de confinement optique supérieure 3 dopée p. Enfin, à la partie supérieure de la couche de confinement 3 on trouve une couche 32 d'arséniure de gallium et d'indium (Ga In As) servant de couche de contact et une électrode métallique 6 permettant d'appliquer un champ électrique.

Le type de matériaux constituant les différentes couches et les épaisseurs de ces couches détermineront le type de laser et notamment la longueur d'onde de fonctionnement du laser.

Par exemple, pour obtenir un laser semiconducteur émettant à 1,3 $\mu$m, on utilisera pour les couches 2, 4, 3 du phosphure d'indium et pour les couches de guidage optique 1,5 on utilisera du phosphure d'arséniure de gallium et d'indium Ga In As P.

La largeur de bande interdite des couches 2, 4, 3 aura donc pour valeur E2 = E3 = E4 = 1,35 eV. Celle des couches de guidage optique 1 et 5 a pour valeur E1 = E5 = 0,95 eV.

Pour minimiser la densité du courant de seuil, l'épaisseur de la couche de guidage optique 1 devrait avoir pour valeur e1 = 0,2 $\mu$m. Celle des couches de confinement 2 et 3 devraient avoir chacune pour valeur e2 = e3 = 1 $\mu$m, l'épaisseur de la couche d'arrêt d'attaque chimique 4 pourra être environ de 100 Angströms.

Le tableau suivant donne approximativement en fonction de l'épaisseur e5 de l'élément de guidage optique 5, les valeurs maximales de la largeur w de l'élément de guidage optique 5 assurant que le guide composite soit monomode transverse :

| $e_5$ | 0,01 | 0,02 | 0,04 | $\mu$m |
|---|---|---|---|---|
| w | 3,3 | 2,3 | 1,6 | $\mu$m |

Selon un autre exemple de réalisation, pour obtenir un laser semiconducteur émettant à 1,55 $\mu$m, on utilisera également pour les couches 2, 3, 4 du phosphure d'indium et pour les couches de guidage optique 1,5 on utilisera du phosphure d'arséniure de gallium et d'indium Ga In As P.

Comme précédemment, la largeur de bande interdite des couches 2, 4, 3 a donc pour valeur E2 = E3 = E4 = 1,35 eV. Celle des couches de guidage optique 1 et 5 a pour valeur E1 = E5 = 0,8 eV.

Pour minimiser la densité du courant de seuil, l'épaisseur de la couche de guidage optique 1 pourrait également avoir pour valeur e1 = 0,2 $\mu$m.

Cette valeur de e1 permettra d'avoir un guide monomode dans la direction Oz et une bonne localisation de l'onde électromagnétique dans la couche de guidage optique 1.

L'épaisseur des couches de confinement 2 et 3 pourront être de e2 = e3 = 1 $\mu$m. L'épaisseur de la couche d'arrêt d'attaque chimique 4 sera de e4 = 100 Angström.

Comme dans l'exemple précédent, la largeur w sera fonction de l'épaisseur e5.

Le guide d'onde de l'invention et le laser semiconducteur mettant en oeuvre ce guide d'onde peut donner lieu à différentes formes de réalisation. Notamment, on peut réaliser sur une même couche d'arrêt d'attaque chimique 4, plusieurs éléments de guidage optique 5.a à 5.d comme cela est représenté en figure 19. Dans le cas d'un laser semiconducteur, on augmentera ainsi la puissance d'émission. Un laser à cavités couplées dans un même mode a ainsi été réalisé avec succès.

On peut également, bien que cela ne soit pas représenté sur les figures, combiner l'exemple de réalisation de la figure 19 avec celui de la figure 8. On obtient alors, sur une même couche d'arrêt d'attaque chimique, plusieurs éléments de guidage optique constitués chacun de sous-couches d'arrêt d'attaque chimique alternées avec des sous-couches de guidage optique.

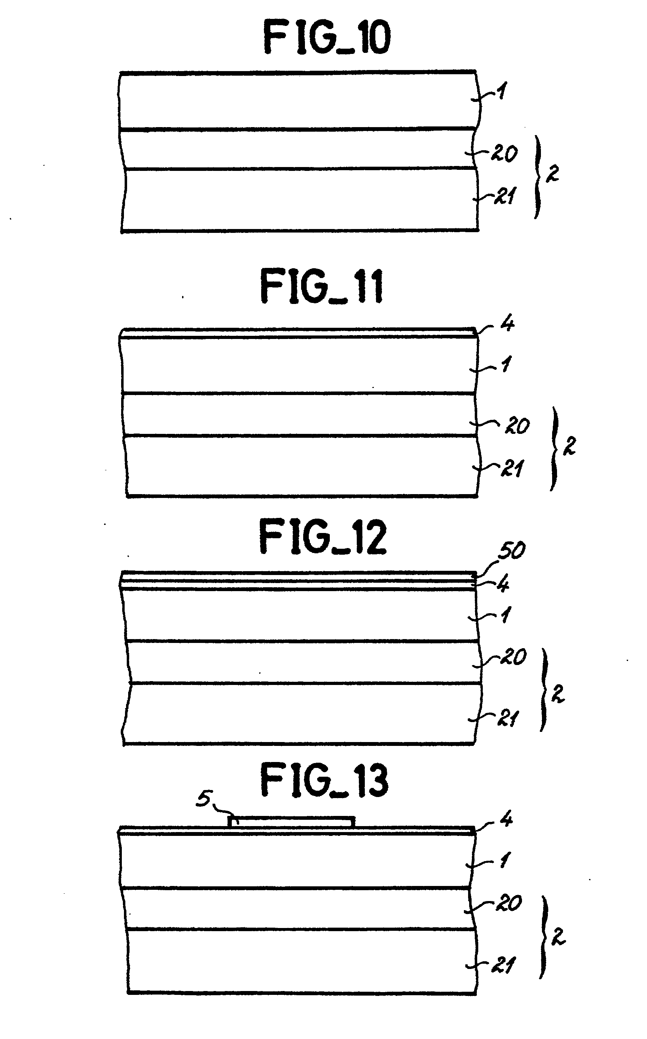

On va maintenant décrire un exemple de procédé de réalisation de l'invention en se reportant aux figures 10 à 15.

Selon une première étape du procédé, on réalise sur une couche de confinement optique inférieure 2, une couche de guidage optique 1. Les matériaux utilisés pour ces deux couches sont adaptés en maille et l'indice de réfraction de la couche 2 est inférieur à l'indice de réfraction de la couche 1. Au préalable, cette étape de réalisation peut comporter la réalisation sur un substrat dopé n+ d'une couche tampon dopée n−.

Pour obtenir une couche de guidage optique 1 de bonne qualité et d'épaisseur uniforme, on pourra réaliser la couche 1 par épitaxie en phase vapeur appelée également en terminologie anglo-saxonne MOCVD (Metalorganic Chemical Vapor Deposition) ou par tout autre procédé tel qu'une épitaxie par jet moléculaire (MBE). On obtient ainsi une structure telle que représentée en figure 10.

Au cours d'une deuxième étape, représentée en figure 11, on réalise sur la couche de guidage optique 1, une couche d'arrêt d'attaque chimique 4. Ces deux couches sont également adaptées en maille. L'indice de réfraction de la couche 4 est inférieur à celui de la couche 1. L'épaisseur de cette couche devant être faible par rapport à la longueur d'onde d'utilisation du guide d'onde et pour avoir une couche 4 uniforme, on utilisera également pour cette étape un procédé tel que mentionné précédemment.

Le matériau utilisé pour la couche 4 sera de nature chimique différente de celui qui sera utilisé dans l'étape qui va suivre pour ne pas être attaqué chimiquement dans une étape d'attaque chimique ultérieure.

Au cours d'une troisième étape, on réalise une couche d'un matériau de guidage optique 50. Le matériau utilisé sera adapté en maille à celui de la couche 1.

Cependant, son épaisseur sera déterminée avec une très grande précision et une excellente uniformité. Pour cela, il est important de préciser que l'invention prévoit une épitaxie qui permet un dépôt uniforme et selon une épaisseur que l'on peut déterminer avec précision.

On obtient ainsi la structure représentée en figure 12.

Au cours d'une quatrième étape, on réalise une attaque chimique de la couche 50 précédemment déposée de façon à découper dans cette couche, un ou plusieurs éléments de guidage optique 5.

La protection de la ou des parties de couche 50 qui doivent donner lieu à ou aux éléments de guidage optique 5 se fait par tout procédé de masquage connu dans la technique.

Le produit chimique utilisé pour l'attaque chimique est choisi de façon à attaquer le matériau de la couche 50 mais à ne pas attaquer le matériau de la couche d'arrêt d'attaque chimique 4.

Ainsi pour ce procédé, la couche 50 ayant été parfaitement calibrée en épaisseur et étant relativement mince on obtient, après attaque chimique, un élément de guidage optique 5 d'épaisseur uniforme et dont les flancs sont découpés avec netteté.

On obtient une structure telle que représentée en figure 13.

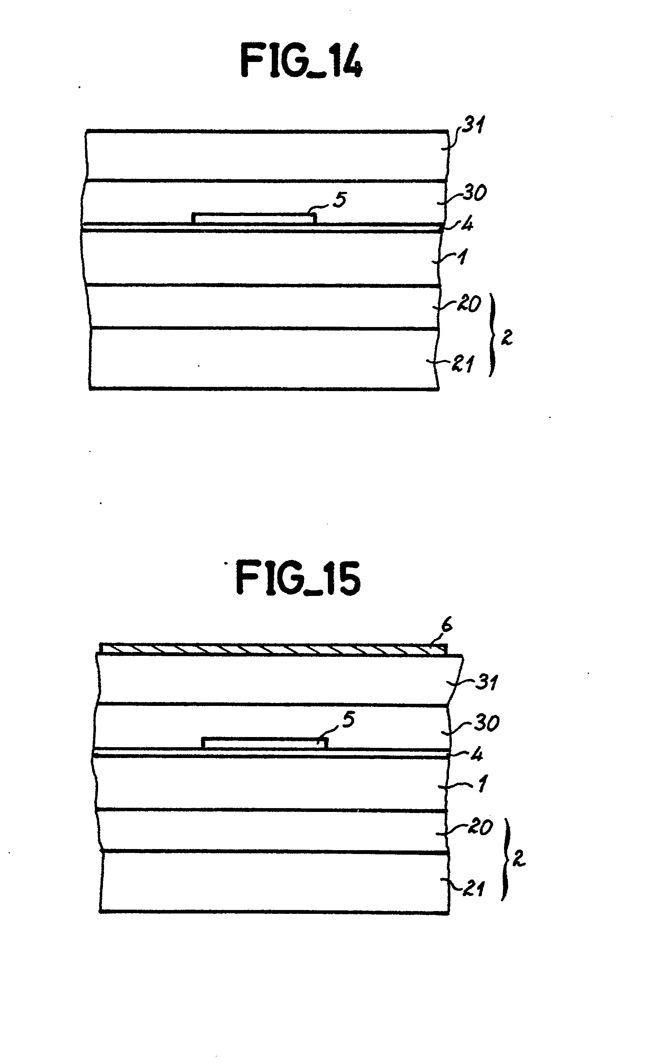

Au cours d'une cinquième étape, on réalise sur l'élément de guidage optique 5 et la couche d'arrêt d'attaque chimique, une couche de confinement optique supérieure 3. Cette couche peut se faire, comme précédemment, par épitaxie en réalisant comme cela est représentée en figure 14, une couche tampon 30 et une couche 31 dopée (p$^+$ par exemple).

Le matériau utilisé pour les couches 30 et 31 est adapté en mailles à l'élément 5 et la couche d'arrêt 4. Son indice de réfraction est inférieur à celui de la couche de guidage 1 et à celui de l'élément 5.

On obtient ainsi une structure guide d'onde.

Pour compléter la structure et obtenir un laser ou modulateur de phase, on réalise, lors d'une étape ultérieure, sur la couche 31, une électrode métallique 6, en platine par exemple. La réalisation d'une telle électrode est connue dans la technique et le procédé de l'invention a permis de réaliser un laser.

Lors du procédé de réalisation ainsi décrit, l'épaisseur des différentes couches et la largeur de l'élément de guidage optique 5 seront choisies en fonction des matériaux utilisés, comme cela a été décrit précédemment, pour déterminer la longueur d'onde optimale de fonctionnement du guide d'onde ou du laser réalisé.

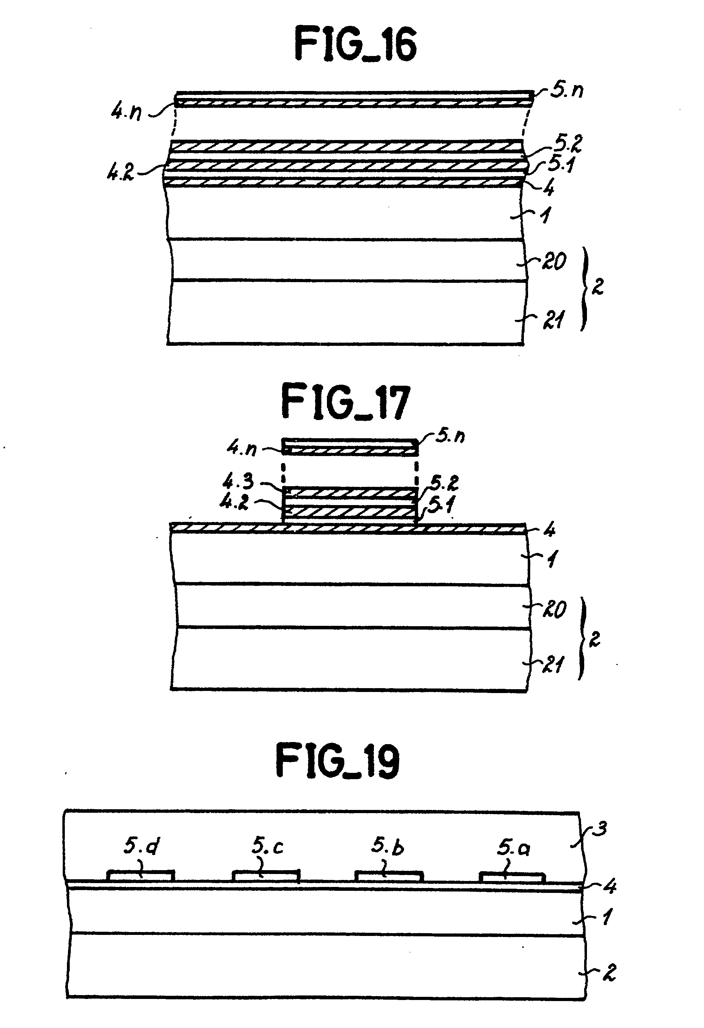

En se reportant aux figures 16 et 17, on va décrire une variante de réalisation du procédé de l'invention.

Selon cette variante, la troisième étape précédemment décrite comporte plusieurs phases alternées de réalisation de sous-couches de matériau de guidage 5.1 à 5.n et de réalisation de sous-couches d'arrêt d'attaque chimique 4.2 à 4.n.

On obtient comme représenté en figure 16, sur la couche de guidage optique 1, un empilement de sous-couches de guidage 5.1 à 5.n et de sous-couches d'arrêt d'attaque chimique 4.2 à 4.n.

Toujours selon la présente variante de réalisation du procédé de l'invention, on prévoit alors que la quatrième étape comporte également une succession alternées de phases d'attaque chimiques. Ces différentes phases utilisent un seul masquage préalable de l'élément de guidage optique à réaliser.

Chaque phase d'attaque chimique se fera à l'aide d'un produit chimique permettant d'attaquer soit une sous-couche de guidage optique 5.1 à 5.n) soit une sous-couche d'arrêt d'attaque chimique (4.2 à 4.n).

Pour des raisons de facilité de mise en oeuvre, le matériau utilisé dans les phases de réalisation des sous-couches de matériau de guidage 5.1 à 5.n sera le même pour toutes les sous-couches. De même, le matériau utilisé dans les phases de réalisation des sous-couches d'arrêt d'attaque chimique 4.2 à 4.n sera le même que celui de la couche 4 déposé lors de la deuxième étape.

Dans ces conditions, on aura recours à deux types d'attaque chimique utilisant deux types de produits chimiques, l'un attaquant les sous-couches 5.1 à 5.n, l'autre attaquant les sous-couches 4.2 à 4.n. On utilisera alternativement l'un et l'autre des produits chimiques de façon à attaquer alternativement les différentes sous-couches. On comptabilisera le nombre de phases d'attaques chimiques, notamment celle d'attaque des sous-couches d'arrêt d'attaque chimique 4.2 à 4.n de façon à stopper la présente quatrième étape après l'attaque de la couche 5.1, avant d'attaquer la couche d'arrêt d'attaque chimique.

Ainsi, selon le procédé de l'invention, on peut réaliser une structure présentant un guidage par indice effectif rendu très faible, typiquement de l'ordre de quelques $10^{-4}$. Ainsi, les éléments de guidage peuvent être plus larges et l'influence de la rugosité des flancs d'attaque sur les pertes, déjà diminuée par la faible hauteur potentielle des éléments de guidage perd encore de l'importance. Pratiquement les pertes de propagation dans cette structure ne devraient être limitées que par les états de surface entre les différentes couches et on devrait obtenir des valeurs de l'ordre de quelques dixièmes de dB/cm. Cette structure enterrée présente un autre avantage si l'on s'intéresse à la modulation hyperfréquence d'un composant optique intégré comme un coupleur directionnel. On sait que sa tension de commande sera minimale s'il présente une longueur de couplage dans la longueur d'interaction, ce qui fige donc l'espace entre les guides. On sait aussi qu'il faudra utiliser des électrodes à ondes progressives dont l'impédance caractéristique va figer l'espace inter électrodes. On comprend qu'il sera beaucoup plus difficile dans la structure "nervure", représentée en figures 1 à 4, de satisfaire ces deux conditions que dans celle que l'on préconise où l'on dispose de quelque lattitude de positionnement des électrodes. Il faut enfin souligner que le problème de la reprise de contact électrique disparait alors que ce n'était pas le cas dans une structure "nervure". En effet, le trop fort guidage par indice effectif n'autorisait que des largeurs de guides faibles (~ 3 μm) pour rester monomode. Souder un fil sur une nervure de cette largeur est tout à fait impossible et il faut avoir recours par exemple au dépôt d'une couche généralement épaisse (quelques microns) de résine isolante jusqu'à la hauteur de la nervure formant guide puis à celui d'une couche d'or déportant le contact au platine sur des surfaces raisonnables pour pouvoir souder des fils d'or.

L'invention ainsi décrite permet aussi d'obtenir une structure laser en matériaux semiconducteurs compatible avec celle employée dans l'optique intégrée tirant partie de la qualité des couches ultra minces obtenues par épitaxie en phase vapeur (MOCVD) ou autre procédé et de leur usinage de grande précision par des solutions d'attaque chimique sélective. Cette structure possède potentiellement des pertes par diffusion très faibles à la propagation lumineuse et constitue donc un atout majeur dans la réalisation de composants optoélectroniques intégrés de très hautes performances.

Il est bien évident que les différents exemples numériques et compositions chimiques n'ont été donnés qu'à titre d'exemple pour illustrer la description, que d'autres exemples peuvent être choisis donnant lieu à d'autres exemples de réalisation. D'autres exemples d'applications de l'invention peuvent être réalisés. Enfin, les procédés de réalisation des couches ainsi que celui de l'attaque de la couche d'arrêt d'attaque chimique peuvent utiliser d'autres méthodes que celles indiquées précédemment.

## Revendications

1. Guide d'onde optique intégré en matériau semiconducteur comprenant au moins une couche d'un matériau de guidage optique (1) d'un premier indice (n1) recouvrant au moins une couche de confinement optique inférieure (2), d'un deuxième indice (n2), au moins un élément de guidage optique (5) en forme de ruban de largeur déterminée, s'étendant au dessus de ladite couche de guidage optique (1) dans la direction de propagation du guide, ledit ruban de guidage (5) ayant un quatrième indice (n5) et au moins une couche de confinement optique supérieure (3), d'un troisième indice (n3), recouvrant ledit ruban de guidage (5) tout en s'étendant de part et d'autre de celui-ci au dessus de ladite couche de guidage (1), le premier indice (n1) étant supérieur au deuxième indice (n2) et au troisième indice (n3) et le quatrième indice (n5) étant également supérieur au troisième indice (n3), ledit guide d'onde étant caractérisé en ce qu'il comporte en outre au moins une couche d'arrêt d'attaque chimique (4) interposée entre ladite couche de guidage (1) d'une part, et ledit ruban de guidage (5) et ladite couche de confinement supérieure (3) d'autre part, l'ensemble étant agencé de sorte que ledit ruban de guidage (5) repose sur ladite couche d'arrêt d'attaque chimique (4) cependant que ladite couche de confinement supérieure (3) recouvre ledit ruban (5) ainsi que ladite couche d'arrêt (4), le matériau de cette couche d'arrêt d'attaque chimique (4) étant de nature chimique différente de celui dudit ruban (5) et l'épaisseur de cette couche d'arrêt d'attaque chimique étant choisie suffisamment faible pour ne pas nuire sensiblement aux qualités optiques dudit guide d'onde.

2. Guide d'onde optique en matériaux semiconducteurs selon la revendication 1, caractérisé en ce que l'épaisseur (h4) de la couche d'arrêt d'attaque chimique est nettement inférieure à la largeur d'onde (λ) de fonctionnement du guide d'onde de façon à ce que cette couche d'arrêt d'attaque chimique (4) n'influence pas les qualités optiques du guide.

3. Guide d'onde optique en matériaux semiconducteurs selon la revendication 1, caractérisé en ce que le quatrième indice (n5) dudit élément de guidage optique (5) est sensiblement égal au premier indice (n1) de la couche de guidage optique (1).

4. Guide d'onde optique en matériaux semiconducteurs selon la revendication 1, caractérisé en ce que la couche de confinement optique inférieure (2) possède une face (20) s'étendant selon un plan (xOy) et que la couche de guidage optique (1) recouvre toute cette face (20).

5. Guide d'onde optique en matériaux semiconducteurs selon la revendication 4, caractérisé en ce que la couche d'arrêt d'attaque chimique (4) recouvre entièrement la couche de guidage optique (1).

6. Guide d'onde optique en matériaux semiconducteurs selon la revendication 5, caractérisé en ce que l'élément de guidage optique (5) a la forme d'un ruban recouvrant partiellement la couche d'arrêt d'attaque chimique (4).

7. Guide d'onde optique en matériaux semiconducteurs selon la revendication 6, caractérisé en ce que la couche de confinement optique supérieure 3 recouvre entièrement l'élément de guidage optique (5) et la couche d'arrêt d'attaque chimique (4) dans les parties où elle n'est pas couverte par l'élément de guidage optique (5).

8. Guide d'onde optique en matériaux semiconducteurs selon la revendication 1, caractérisé en ce que la couche d'arrêt d'attaque chimique (4) a une épaisseur inférieure au dixième de la valeur de la longueur d'onde de fonctionnement du guide d'onde.

9. Guide d'onde optique en matériaux semiconducteurs selon la revendication 1, caractérisé en ce que la couche de confinement optique inférieure (2), la couche d'arrêt d'attaque chimique (4), la couche de confinement optique supérieure (3), la couche de guidage optique (1), l'élément de guidage optique (5) ont une largeur de bande interdite égale respectivement à une première valeur (E2), deuxième valeur (E4), troisième valeur (E3), quatrième valeur (E1) et une cinquième valeur (E5), chacune des trois premières valeurs (E2, E4, E3) étant supérieure à chacune des quatrième et cinquième valeurs (E1 et E5) prises séparément.

10. Guide d'onde optique en matériaux semiconducteurs selon la revendication 9, caractérisé en ce que les trois premières dites valeurs (E2, E4, E3) sont égales.

11. Guide d'onde optique en matériaux semiconducteurs selon la revendication 9, caractérisé en ce que les deux dernières dites valeurs (E1) et E5) sont égales.

12. Guide d'onde optique en matériaux semiconducteurs selon la revendication 6, dans lequel l'élément de guidage optique (5) en forme de ruban est parallèle au plan xOy et parallèle à la direction Ox, caractérisé en ce que l'élément de guidage optique (5) a une largeur (w) selon la direction Oy telle que selon les indices de réfraction des différentes couches (1, 2, 3, 5) et de l'élément de guidage (5) ainsi que selon leur épaisseur, le guide d'onde obtenu soit monomode aussi bien selon la direction Oy que selon une direction Oz perpendiculaire au plan xOy pour une onde se propageant selon la direction Ox.

13. Guide d'onde optique en matériaux semiconducteurs selon la revendication 6, dans lequel l'élément de guidage optique (5) en forme de ruban est parallèle au plan xOy et parallèle à la direction Ox, caractérisé en ce que l'élément de guidage optique (5) a une largeur (w) selon la direction Oy telle que selon les indices de réfraction des différente couches (1, 2, 3, 5) et de l'élément de guidage (5) ainsi que selon leur épaisseur, le guide d'onde obtenu soit bimode pour une onde se propageant selon la direction Ox.

14. Guide d'onde optique en matériaux semiconducteurs selon la revendication 1, caractérisé en ce que l'élément de guidage (5) a une épaisseur inférieure au centième de la valeur de la longueur d'onde de fonctionnement du guide d'onde de façon à constituer un puits quantique pur augmenter l'énergie du seuil d'absorption du matériau et par suite réduire les pertes du guide d'onde.

15. Guide d'onde optique en matériaux semiconducteurs selon la revendication 14, caractérisé en ce que les quatrième et cinquième valeurs (E1 et E5) de largeurs de bandes interdites de la couche de guidage optique (1) et de l'élément de guidage optique (5) sont égales.

16. Guide d'onde optique en matériaux semiconducteurs selon l'une quelconque des revendications précédentes, caractérisé en ce que l'élément de guidage optique (5) comporte parallèlement au plan xOy:
– un nombre déterminé n de sous-couches de guidage optique (5.1 à 5.n) chacune en un matériau dont l'indice est supérieur au troisième indice (n3) de la couche de confinement optique supérieure (3);
– ces différentes sous-couches de guidage optique étant séparées les unes des autres par des sous-couches d'arrêt d'attaque chimique (4.2 à 4.n) chacune d'épaisseur nettement inférieure à la longueur (λ) de fonctionnement du guide d'onde.

17. Guide d'onde optique en matériaux semiconducteurs selon la revendication 16, caractérisé en ce que chaque sous-couche de guidage optique (5.1 à 5.n) et chaque sous-couche d'arrêt d'attaque chimique (4.2 à 4.n) ont chacune une épaisseur et une largeur de bande interdite telles que définies pour l'élément de guidage optique (5) et pour la couche d'arrêt d'attaque chimique (4) dans l'une quelconque des revendications 8, 9 et 10 à 14.

18. Guide d'onde optique en matériaux semiconducteurs selon la revendication 16, caractérisé en ce que les différentes sous-couches de guidage optique (5.1 à 5.n) sont identiques entre elles et que les différentes sous-couches d'arrêt d'attaque chimique (4.2 à 4.n) sont identiques à la couche d'arrêt d'attaque chimique (4).

19. Guide d'onde optique en matériaux semiconducteurs selon l'une quelconque des revendications précédentes, caractérisé en ce qu'il comporte sur la couche d'arrêt d'attaque chimique (4) plusieurs éléments de guidage optique (5a à 5d).

20. Guide d'onde optique en matériaux semiconducteurs selon l'une quelconque des revendications précédentes, caractérisé en ce que chaque couche (1, 2, 3, 4) et les éléments de guidage optique 5 sont en matériaux semiconducteurs.

21. Guide d'onde optique en matériaux semiconducteurs selon la revendication 20, caractérisé en ce que les matériaux semi-conducteurs utilisés sont des composés des groupes 111 et V de la classification périodique des éléments.

22. Guide d'onde optique en matériaux semiconducteurs selon la revendication 21, caractérisé en ce que le paramètre de maille de chaque couche est adapté à un multiple ou sous-multiple des paramètres de mailles des couches voisines.

23. Guide d'onde optique en matériaux semiconducteurs selon la revendication 21, caractérisé en ce que les couches de confinement optique inférieure et supérieure (2 et 3), la couche d'arrêt d'attaque chimique (4) et les sous-couches d'arrêt d'attaque chimique (4.2 à 4.n) sont des composés binaires.

24. Guide d'onde optique en matériaux semiconducteurs selon la revendication 21, caractérisé en ce que la couche de guidage optique (1) et les sous-couches de guidage optique (5.1 à 5.n) sont des composés ternaires ou quaternaires.

25 . Guide d'onde optique en matériaux semiconducteurs selon la revendication 23, caractérisé en ce que les couches de confinement optique (2 et 3) ainsi que les couches et sous-couches d'arrêt d'attaque chimique (4, 4.2 à 4.n) sont en matériau identique.

26. Guide d'onde optique en matériaux semiconducteurs selon la revendication 24, caractérisé en ce que la couche de guidage optique (5) et les sous-couches de guidage optique (5.1 à 5.n) sont en un même matériau.

27. Guide d'onde optique en matériaux semiconducteurs selon la revendication 25, caractérisé en ce que les couches de confinement optique (2 et 3) et les couches et sous-couches d'arrêt d'attaque chimique (4, 4.2 à 4.n) sont en phosphure d'indium (InP).

28. Guide d'onde optique en matériau semiconducteur selon la revendication 26, caractérisé en ce que la couche de guidage optique (5) et les sous-couches de guidage optique (5.1 à 5.n) sont en arséniure de Gallium et d'Indium (In Ga As) ou en phosphure S d'arséniure de gallium et d'indium (In Ga As P).

29. Guide d'onde optique en matériaux semiconducteurs selon la revendication 20, caractérisé en ce que la couche de confinement optique inférieure (2) comporte une couche de substrat dopé $n^+$ (21) et couche tampon dopée $n^-$ (20) celle-ci étant en contact avec la couche de guidage optique 1, tandis que la couche de confinement supérieure (3) comporte, en contact avec la couche d'arrêt chimique (4) et l'élément de guidage optique (5), une couche tampon dopée $n^-$.

30. Laser à semiconducteur comprenant le guide d'onde selon l'une quelconque des revendications précédentes, selon lequel:
– ladite couche de confinement optique inférieure (2) comprend un substrat (21) en un matériau semiconducteur dopé d'un type déterminé (n), de paramètre de maille et de largeur de bande interdite déterminées;
– ladite couche de guidage optique (1) servant de zone active est en un matériau semiconducteur de paramètre de maille adapté à un multiple ou sous-multiple de celui de la couche de confinement optique inférieure (2) et de largeur de bande interdite inférieure à celle de la couche de confinement optique inférieure (2);
– l'adite couche d'arrêt d'attaque chimique (4) a un paramètre de maille adapté à un multiple ou sous-multiple de celui de la couche de guidage optique (1);
– ladite couche de confinement optique supérieure (3) est en un matériau semiconducteur dopé de type contraire (p) à celui de la couche de confinement optique inférieure (2) et de paramètre de maille adapté à celui de la couche d'arrêt d'attaque chimique (4) et de largeur de bande interdite supérieure à celle de la couche de guidage optique (1) et de l'élément de guidage optique (5);
– et selon lequel au moins deux électrodes conductrices (6) sont appliquées au guide d'onde.

31. Laser à semiconducteurs selon la revendication 30, caractérisé en ce que la couche de confinement optique inférieure (2) comporte également, entre le substrat (21) et la couche de guidage optique (1), une couche tampon (20) d'un même matériau que le substrat (21) mais plus faiblement dopé. I

32. Procédé de réalisation d'un guide d'onde en matériaux semiconducteurs ou d'un laser semiconducteur utilisant un tel guide d'onde, comportant les étapes suivantes:
a) une première étape de réalisation sur un substrat en matériau semiconducteur et recouvert d'une couche de confinement optique (2), d'une couche d'un matériau de guidage optique (1) dont le paramètre de maille est adapté à celui du matériau de la couche de confinement optique (2) et dont la largeur de bande interdite est inférieure à celle du matériau de la couche de confinement;
b) une deuxième étape de réalisation sur la couche de guidage optique (I) d'une couche d'arrêt d'attaque chimique (4) en matériau dont le paramètre de maille est adapté à celui du matériau de la couche de guidage optique (1);
c) une troisième étape de réalisation sur la couche d'arrêt d'attaque chimique (4) d'une couche d'un matériau de guidage optique (50) dont le paramètre de maille est adapté a celui du matériau de la couche d'arrêt d'attaque chimique (4);
d) une quatrième étape d'attaque chimique de la couche de matériau de guidage optique (50) à l'aide d'un produit n'yant aucune action sur la couche d'arrêt d'attaque chimique (4), de façon à réaliser au moins un élément de guidage optique (5) en forme de ruban de largeur déterminée;
e) une cinquième étape de réalisation sur le ruban (5) et sur la couche d'arrrêt d'attaque chimique (4) non couverte par ce ruban, d'une couche de confinement optique supérieure (3) en un matériau semiconducteur de paramètre de maille adapté à ceux de l'élément de guidage optique (5) et de la couche d'arrêt d'attaque chimique (4) et de largeur de bande d'énergie supérieure à celle de l'élément de guidage optique (5) et de la couche de guidage optique (1).

33. Procédé de réalisation selon la revendication 33, caractérisé en ce que les étapes de réalisation des couches (1, 4, 5, 3) se font par un procédé d'épitaxie.

34. Procédé de réalisation selon la revendication 33, caractérisé en cc que le procédé d'épitaxie est une épitaxie en phase vapeur.

35. Procédé de réalisation selon la revendication 32, caractérisé en ce que l'épaisseur de la couche d'arrêt d'attaque chimique (4) a une épaisseur nettement inférieure à la valeur de la longueur d'onde de fonctionnement du guide d'onde.

36. Procédé de réalisation selon la revendication 32, caractérisé en ce que d'une part, les matériaux utilisés pour la réalisation du substrat (2), de la couche de confinement optique (3) et de la couche d'arrêt d'attaque chimique (4) sont identiques et que d'autre part les matériaux utilisés pour la réalisation des couches de matériaux de guidage (1 et 50) sont identiques.

37. Procédé de réalisation selon la revendication 32, caractérisé en ce que:
- la troisième étape comporte une succession alternée de phases de réalisation de sous-couches de matériau de guidage optique (5.1 à 5.n) et de phases de réalisation de sous-couches d'arrêt d'attaque chimique (4.2 à 4.n);
- la quatrième étape comporte une succession alternée de phases d'attaques chimiques permettant d'attaquer les sous-couches de matériau de guidage (5.1 à 5.n) et de phases d'attaques permettant d'attaquer les sous-couches d'arrêt d'attaque chimique (4.2 à 4.n).

38. Procédé de réalisation selon la revendication 37, caractérisé en ce que:
- les sous-couches de matériau de guidage optique (5.1 à 5.n) sont en un même matériau;
- les sous-couches d'arrêt d'attaque chimique (4.2 à 4.n) sont en un même matériau que la couche d'arrêt d'attaque chimique 4;
- les phases d'attaques chimiques permettant d'attaquer les sous-couches de matériau de guidage (5.1 à 5.n) étant toutes d'un premier type;
- les phases d'attaques chimiques permettant d'attaquer les sous-couches d'arrêt d'attaques chimiques étant par ailleurs toutes d'un deuxième type;
- les différentes phases d'attaques chimiques étant comptées  pour éviter, avec une phase d'attaque chimique du deuxième type, d'attaquer la couche d'arrêt d'attaque chimique 4.

**Patentansprüche**

1. Integrierter Lichtleiter aus Halbleitermaterial, der mindestens eine Schicht (1) eines lichtleitenden Materials mit einem ersten Brechungsindex (n1), welche mindestens eine untere optische Einschließungsschicht (2) mit einem zweiten Brechungsindex (n2) bedeckt, mindestens ein Lichtleitelement (5) in Form eines Bandes bestimmter Breite, das sich oberhalb der lichtleitenden Schicht (1) in Fortpflanzungsrichtung des Lichts erstreckt und einen vierten Brechungsindex (n5) besitzt, und mindestens eine obere optische Einschließungsschicht (3) mit einem dritten Brechungsindex (n3) aufweist, die das bandförmige Lichtleitelement (5) bedeckt und sich zu beiden Seiten dieses Elements oberhalb der Schicht aus lichtleitendem Material (1) erstreckt, wobei der erste Brechungsindex (n1) größer als der zweite (n2) und der dritte Brechungsindex (n3) ist und der vierte Brechungsindex (n5) ebenfalls größer als der dritte Brechungsindex (n3) ist, dadurch gekennzeichnet, daß der Lichtleiter weiter mindestens eine Schutzschicht gegen chemische Angriffe (4) aufweist, die zwischen der Schicht aus lichtleitendem Material (1) einerseits und dem bandförmigen Lichtleitelement (5) und der oberen Einschliessungsschicht (3) andererseits eingefügt ist, wobei die Anordnung so gewählt ist, daß das bandförmige Lichtleitelement (5) auf der Schutzschicht (4) ruht, während die obere Einschliessungsschicht (3) das bandförmige Lichtleitelement (5) sowie diese Schutzschicht (4) bedeckt, und wobei die Schutzschicht (4) gegen chemische Angriffe von anderer chemischer Art als das bandförmige Lichtleitelement (5) ist und die Dicke dieser Schutzschicht ausreichend gering gewählt ist, um keine wesentliche Beeinträchtigung der optischen Qualitäten des Lichtleiters zu verursachen.

2. Lichtleiter aus Halbleitermaterialien nach Anspruch 1, dadurch gekennzeichnet, daß die Dicke (h4) der chemischen Schutzschicht deutlich geringer als die Betriebswellenlänge ($\lambda$) im Lichtwellenleiter ist, derart, daß die chemische Schutzschicht (4) die optischen Qualitäten des Lichtleiters nicht beeinflußt.

3. Lichtleiter aus Halbleitermaterialien nach Anspruch 1, dadurch gekennzeichnet, daß der vierte Brechungsindex (n5) des bandförmigen Lichtleitelements (5) dem Brechungsindex (n1) der Schicht (1) aus lichtleitendem Material im wesentlichen gleicht.

4. Lichtleiter aus Halbleitermaterialien nach Anspruch 1, dadurch gekennzeichnet, daß die untere optische Einschliessungsschicht (2) eine Fläche (20) besitzt, die sich in einer Ebene (xOy) erstreckt und daß diese Schicht (1) aus lichtleitendem Material diese ganze Fläche (20) bedeckt.

5. Lichtleiter aus Halbleitermaterialien nach Anspruch 4, dadurch gekennzeichnet, daß die chemische Schutzschicht (4) die Schicht (1) aus lichtleitendem Material völlig bedeckt.

6. Lichtleiter aus Halbleitermaterialien nach Anspruch 5, dadurch gekennzeichnet, daß das bandförmige Lichtleitelement (5) als teilweise die chemische Schutzschicht (4) bedeckendes Band ausgebildet ist.

7. Lichtleiter aus Halbleitermaterialien nach Anspruch 6, dadurch gekennzeichnet, daß die obere optische Einschließungsschicht (3) das bandförmige Lichtleitelement (5) sowie die chemische Schutzschicht (4) in den Bereichen, in denen sie nicht vom bandförmigen Lichtleitelement bedeckt ist, vollständig bedeckt.

8. Lichtleiter aus Halbleitermaterialien nach Anspruch 1, dadurch gekennzeichnet, daß die chemische Schutzschicht (4) eine Dicke besitzt, die geringer als ein Zehntel des Werts der Betriebswellenlänge des Lichtleiters ist.

9. Lichtleiter aus Halbleitermaterialien nach Anspruch 1, dadurch gekennzeichnet, daß die untere optische Einschliessungsschicht (2), die chemische Schutzschicht (4), die obere optische Einschließungsschicht (3), die Schicht aus lichtleitendem Material (1) und das bandförmige Lichtleitelement (5) eine Breite des verbotenen Bandes haben, die einen ersten (E2), einen zweiten (E4), einen dritten (E3), einen vierten (E1) bzw. einen fünften Wert (E5) besitzt, wobei jeder der drei ersten Werte (E2, E4, E3) größer als jeder einzelne der vierten und fünften Werte (E1, E5) ist.

10. Lichtleiter aus Halbleitermaterialien nach Anspruch 9, dadurch gekennzeichnet, daß die drei ersten Werte (E2, E4, E3) gleich sind.

11. Lichtleiter aus Halbleitermaterialien nach Anspruch 9, dadurch gekennzeichnet, daß die beiden letzten Werte (E1, E5) gleich sind.

12. Lichtleiter aus Halbleitermaterialien nach Anspruch 6, in dem das bandförmige Lichtleitelement (5) parallel zur Ebene xOy und parallel zur Richtung Ox verläuft, dadurch gekennzeichnet, daß das bandförmige Lichtleitelement (5) eine solche Breite (w) in Richtung Oy besitzt, daß der so erhaltene Lichtleiter aufgrund der Brechungsindices der verschiedenen Schichten (1, 2, 3, 5) und des bandförmigen Lichtleitelements (5) sowie deren Dicke, ein Monomodelichtleiter sowohl in Richtung Oy wie in einer Richtung Oz senkrecht zur Ebene xOy für eine Welle ist, die sich in Richtung Ox ausbreitet.

13. Lichtleiter aus Halbleitermaterialien nach Anspruch 6, in dem das bandförmige Lichtleitelement (5) parallel zur Ebene xOy und zur Richtung Ox verläuft, dadurch gekennzeichnet, daß das bandförmige Lichtleitelement (5) eine solche Breite (w) in Richtung Oy besitzt, daß aufgrund der Brechungsindices der verschiedenen Schichten (1, 2, 3, 5) und des bandförmigen Lichtleitelements (5) sowie aufgrund deren Dicke der erhaltene Lichtleiter für eine sich in Richtung Ox fortpflanzende Welle bimodal ist.

14. Lichtleiter aus Halbleitermaterialien nach Anspruch 1, dadurch gekennzeichnet, daß das bandförmige Lichtleitelement (5) eine Dicke besitzt, die geringer als ein Hundertstel des Werts der Betriebswellenlänge des Lichtleiters ist, so daß es einen Quantenbrunnen bildet, um die Energie der Absorptionsschwelle des Materials zu vergrößern und damit die Verluste des Wellenleiters zu verringern.

15. Lichtleiter aus Halbleitermaterialien nach Anspruch 14, dadurch gekennzeichnet, daß der vierte (E1) und der fünfte Wert (E5) der Breite des verbotenen Bandes in der Schicht (1) aus lichtleitendem Material bzw. dem bandförmigen Lichtleitelement (5) gleich sind.

16. Lichtleiter aus Halbleitermaterialien nach einem beliebigen der vorhergehenden Ansprüche, dadurch gekennzeichnet, daß das bandförmige Lichtleitelement (5) parallel zur Ebene xOy
– eine bestimmte Anzahl n von Lichtleit-Unterschichten (5.1 bis 5.n) aufweist, die je aus einem Material bestehen, dessen Brechungsindex größer als der dritte Brechungsindex (n3) der oberen optischen Einschließungsschicht (3) ist,
– wobei diese verschiedenen Unterschichten voneinander durch Unterschichten zum Schutz gegen chemische Angriffe (4.2 bis 4.n) voneinander getrennt sind, deren Dicke je deutlich geringer als die Betriebswellenlänge ($\lambda$) des Wellenleiters gewählt ist.

17. Lichtleiter aus Halbleitermaterialien nach Anspruch 16, dadurch gekennzeichnet, daß jede Lichtleit-Unterschicht (5.1 bis 5.n) und jede Unterschicht zum Schutz gegen chemische Angriffe (4.2 bis 4.n) eine Dicke und eine Breite des verbotenen Bands besitzt, wie sie für das bandförmige Lichtleitelement (5) und für die chemische Schutzschicht (4) in einem beliebigen der Ansprüche 8, 9 und 10 bis 14 definiert wurden.

18. Lichtleiter aus Halbleitermaterialien nach Anspruch 16, dadurch gekennzeichnet, daß die verschiedenen lichtleitenden Unterschichten (5.1 bis 5.n) einander gleich sind und daß die verschiedenen Unterschichten zum Schutz gegen chemische Angriffe (4.2 bis 4.n) der chemischen Schutzschicht (4) gleichen.

19. Lichtleiter aus Halbleitermaterialien nach einem beliebigen der vorhergehenden Ansprüche, dadurch gekennzeichnet, daß auf der chemischen Schutzschicht (4) mehrere Lichtleitelemente (5a bis 5d) angeordnet sind.

20. Lichtleiter aus Halbleitermaterialien nach einem beliebigen der vorhergehenden Ansprüche, dadurch gekennzeichnet, daß jede Schicht (1, 2, 3, 4) und die bandförmigen Lichtleitelemente (5) aus Halbleitermaterialien bestehen.

21. Lichtleiter aus Halbleitermaterialien nach Anspruch 20, dadurch gekennzeichnet, daß die verwendeten Halbleitermaterialien Stoffe aus den Gruppen III und V des Periodischen Systems der Elemente sind.

22. Lichtleiter aus Halbleitermaterialien nach Anspruch 21, dadurch gekennzeichnet, daß der Maschenparameter jeder Schicht einem Vielfachen oder Untervielfachen der Maschenparameter der Nachbarschichten angepaßt ist.

23. Lichtleiter aus Halbleitermaterialien nach Anspruch 21, dadurch gekennzeichnet, daß die untere und die obere optische Einschließungschicht (2 und 3), die chemische Schutzschicht (4) und die Unterschichten zum Schutz gegen chemische Angriffe (4.2 bis 4.n) binäre Stoffverbindungen sind.

24. Lichtleiter aus Halbleitermaterialien nach Anspruch 21, dadurch gekennzeichnet, daß die Schicht aus lichtleitendem Material (1) und die lichtleitenden Unterschichten (5.1 bis 5.n) ternäre oder quaternäre Stoffverbindungen sind.

25. Lichtleiter aus Halbleitermaterialien nach Anspruch 23, dadurch gekennzeichnet, daß die optischen Einschließungsschichten (2 und 3) sowie die Schichten und Unterschichten zum Schutz gegen chemische Angriffe (4, 4.2 bis 4.n) aus demselben Material bestehen.

26. Lichtleiter aus Halbleitermaterialien nach Anspruch 24, dadurch gekennzeichnet, daß die Lichtleitschicht (5) und die lichtleitenden Unterschichten (5.1 bis 5.n) aus demselben Material bestehen.

27. Lichtleiter aus Halbleitermaterialien nach Anspruch 25, dadurch gekennzeichnet, daß die optischen Einschließungsschichten (2, 3) und die Schichten und Unterschichten zum Schutz gegen chemische Angriffe (4, 4.2 bis 4.n) aus Indium-Phosphid (InP) bestehen.

28. Lichtleiter aus Halbleitermaterialien nach Anspruch 26, dadurch gekennzeichnet, daß die Lichtleiterschicht (5) und die lichtleitenden Unterschichten (5.1 bis 5.n) aus Gallium-Indium-Arsenid (InGaAs) oder aus Gallium-Indium-Arsenid-Phosphid (InGaAsP) bestehen.

29. Lichtleiter aus Halbleitermaterialien nach Anspruch 20, dadurch gekennzeichnet, daß die untere optische Einschließungsschicht (2) eine Substratschicht (21) mit $n^+$-Dotierung und eine Pufferschicht (20) mit $n^-$-Dotierung besitzt, wobei letztere mit der Schicht (1) aus lichtleitendem Material in Berührung steht, während die obere optische Einschließungsschicht (3) in Kontakt mit der chemischen Schutzschicht (4) und dem Lichtleitelement (5) eine Pufferschicht aufweist, die $n^-$-dotiert ist.

30. Halbleiterlaser mit einem Lichtleiter nach einem beliebigen der vorhergehenden Ansprüche,
– bei dem die untere optische Einschließungsschicht (2) ein Substrat (21) aus einem Halbleitermaterial besitzt, das eine bestimmte Dotierung (n) sowie einen bestimmten Maschenparameter und eine bestimmte Breite des verbotenen Bandes besitzt,
– bei dem die Schicht aus lichtleitendem Material (1), die als aktive Zone wirkt, aus einem Halbleitermaterial besteht, dessen Maschenparameter an ein Vielfaches oder Untervielfaches des Maschenparameters der unteren optischen Einschließungsschicht (2) angepaßt ist und dessen Breite des verbotenen Bandes geringer als die der unteren optischen Einschließungsschicht ist,
– bei dem die chemische Schutzschicht (4) einen Maschenparameter besitzt, der einem Vielfachen oder Untervielfachen des Maschenparameters der Schicht aus lichtleitendem Material (1) angepaßt ist,
– bei dem die obere optische Einschließungsschicht (3) aus einem Halbleitermaterial besteht, das eine entgegengesetzte Dotierung (p) zu der der unteren optischen Einschließungsschicht (2) sowie einen Maschenparameter aufweist, der dem der chemischen Schutzschicht (4) angepaßt ist, sowie eine Breite des verbotenen Bandes aufweist, die größer als die der Schicht aus lichtleitendem Material (1) und des Lichtleitelements (5) ist,
– und bei dem mindestens zwei leitende Elektroden (6) an den Lichtleiter angelegt sind.

31. Halbleiterlaser nach Anspruch 30, dadurch gekennzeichnet, daß die untere optische Einschließungsschicht (2) außerdem zwischen dem Substrat (21) und der Schicht (1) aus lichtleitendem Material eine Pufferschicht (20) desselben Materials wie das Substrat (21) besitzt, wobei jedoch die Dotierung schwächer ist.

32. Verfahren zur Herstellung eines Lichtleiters aus Halbleitermaterialien oder eines Halbleiterlasers, der einen solchen Lichtleiter verwendet, das folgende Verfahrensschritte aufweist:
a) einen ersten Verfahrensschritt, in dem auf einem mit einer optischen Einschließungsschicht (2) bedeckten Substrat aus Halbleitermaterial eine Schicht eines lichtleitenden Materials (1) hergestellt wird, deren Maschenparameter dem des Materials der optischen Einschließungsschicht (2) angepaßt ist und deren Breite des verbotenen Bandes geringer als die des Materials der Einschließungsschicht ist,
b) einen zweiten Verfahrensschritt, in dem auf der Schicht aus lichtleitendem Material (1) eine Schicht zum Schutz gegen chemische Angriffe (4) aus einem Material hergestellt wird, dessen Maschenparameter dem des Materials der Schicht (1) angepaßt ist,
c) einen dritten Verfahrensschritt, in dem auf der chemischen Schutzschicht (4) eine Schicht aus einem Lichtleitmaterial (50) hergestellt wird, deren Maschenparameter dem des Materials der chemischen Schutzschicht (4) angepaßt ist,
d) einen vierten Verfahrensschritt, in dem die Schicht (50) aus Lichtleitmaterial mit Hilfe eines Produkts geätzt wird, das keine Wirkung auf die chemische Schutzschicht (4) hat, so daß mindestens ein bandförmiges Lichtleitelement (5) einer bestimmten Breite entsteht,
e) einen fünften Verfahrensschritt, in dem auf dem bandförmigen Lichtleitelement (5) und auf der chemischen Schutzschicht (4), soweit sie nicht von diesem bandförmigen Element bedeckt ist, eine obere optische Einschließungsschicht (3) aus einem Halbleitermaterial hergestellt wird, dessen Maschenparameter denen des Lichtleitelements (5) und der chemischen Schutzschicht (4) angepaßt ist und dessen Breite des Energiebands größer als die des Lichtleitelements (5) und der Schicht (1) aus lichtleitendem Material ist.

33. Herstellungsverfahren nach Anspruch 32, dadurch gekennzeichnet, daß die Schichten (1, 4, 5, 3) durch ein Epitaxieverfahren hergestellt werden.

34. Herstellungsverfahren nach Anspruch 33, dadurch gekennzeichnet, daß das Epitaxieverfahren ein Epitaxieverfahren aus der Dampfphase ist. 35. Herstellungsverfahren nach Anspruch 32, dadurch gekennzeichnet, daß die Schutzschicht gegen chemische Angriffe (4) eine Dicke besitzt, die deutlich geringer als der Wert der Betriebswellenlänge des Lichtleiters ist.

36. Herstellungsverfahren nach Anspruch 32, dadurch gekennzeichnet, daß einerseits die für die Herstellung des Substrats (2), der optischen Einschließungsschicht (3) und der chemischen Schutzschicht (4) verwendeten Materialien gleich sind, und andererseits die für die Herstellung der Lichtleitschichten (1, 50) verwendeten Materialien einander gleich sind.

37. Herstellungsverfahren nach Anspruch 32, dadurch gekennzeichnet, daß
– der dritte Verfahrensschritt eine abwechselnde Folge der Herstellung von Unterschichten aus einem Lichtleitmaterial (5.1 bis 5.n) und der Herstellung von Unterschichten zum Schutz gegen chemischen Angriff (4.2 bis 4.n) aufweist,
– der vierte Verfahrensschritt eine abwechselnde Folge von chemischen Ätzphasen, mit denen die Unterschichten aus lichtleitendem Material (5.1 bis 5.n) angegriffen werden können, und von Phasen enthält, in denen die Unterschichten zum Schutz gegen chemischen Angriff (4.2 bis 4.n) geätzt werden können.

38. Herstellungsverfahren nach Anspruch 37, dadurch gekennzeichnet, daß
– die Unterschichten aus lichtleitendem Material (5.1 bis 5.n) alle aus demselben Material bestehen,
– die Unterschichten zum Schutz gegen chemischen Angriff (4.2 bis 4.n) alle aus demselben Material wie die chemische Schutzschicht (4) bestehen,
– die chemischen Ätzphasen, in denen die Unterschichten des lichtleitenden Materials (5.1 bis 5.n) geätzt werden, alle von einer ersten Art sind,
– die Phasen, in denen die Unterschichten zum Schutz gegen chemische Angriffe geätzt werden, im übrigen alle von einer zweiten Art sind,
– die verschiedenen chemischen Ätzphasen gezählt werden, um zu verhindern, daß mit einer chemischen Ätzphase von der zweiten Art die chemische Schutzschicht (4) angegriffen wird.

## Claims

1. An integrated semiconductor optical waveguide comprising at least one layer of an optical waveguide material (1) having a first index (n1), this layer covering at least one lower optical confinement layer (2) having a second index (n2), at least one optical waveguide element consisting of a strip of a given width and extending above said optical waveguide layer (1) in the direction of propagation in the guide, said waveguide strip (5) having a fourth index (n5), and at least one upper optical confinement layer (3) having a third index (n3) and covering said waveguide strip (5) while projecting therebeyond on both sides above said waveguide layer (1), the first index (nl) exceeding the second index (n2) and the third index (n3), while the fourth index (n5) exceeds the third index (n3), characterized in that it further comprises at least one stop layer against chemical attack (4) which is interposed between said waveguide layer (1) on the one hand and said waveguide strip (5) and said upper confinement layer (3) on the other hand, the entire assembly being arranged such that said waveguide strip (5) is laid upon said chemical attack stop layer (4), whereas said upper confinement layer (3) covers said strip (5) as well as the stop layer (4), the material of this chemical attack stop layer (4) having a chemical composition differing from that of the strip (5) and the thickness of this chemical attack stop layer being sufficiently small to avoid any substantial prejudice to the optical qualities of the waveguide.

2. An optical waveguide made of semiconductor materials according to claim 1, characterized in that the thickness (h4) of the chemical attack stop layer is substantially smaller than the operational wavelength ($\lambda$) of the waveguide such that the chemical attack stop layer (4) does not influence the optical qualities of the waveguide.

3. An optical waveguide made of semiconductor materials according to claim 1, characterized in that the fourth index (n5) of said optical waveguide element (5) is substantially equal to the first index (n1) of the optical waveguide layer (1).

4. An optical waveguide made of semiconductor materials according to claim 1, characterized in that the lower optical confinement layer (2) presents a surface (20) which extends in a plane (xOy), and that the optical waveguide layer (1) covers this entire surface (20).

5. An optical waveguide made of semiconductor materials according to claim 4, characterized in that the chemical attack stop layer (4) completely covers the optical waveguide layer(1).

6. An optical waveguide made of semiconductor materials according to claim 5, characterized in that the optical waveguide element (5) presents a strip-like shape and partially covers the chemical attack stop layer (4).

7. An optical waveguide made of semiconductor materials according to claim 6, characterized in that the upper optical confinement layer (3) completely covers the optical waveguide element (5) and the chemical attack stop layer (4) in those portions in which it is not covered by the optical waveguide element (5).

8. An optical waveguide made of semiconductor materials according to claim 1, characterized in that the chemical attack stop layer (4) presents a thickness which is smaller than one tenth of the operational wavelength of the waveguide.

9. An optical waveguide made of semiconductor materials according to claim 1, characterized in that the lower optical confinement layer (2), the chemical attack stop layer (4), the upper optical confinement layer (3), the optical waveguide layer (1), the optical waveguide element (5) present a width of the forbidden band which amounts respectively to a first value (E2), a second value (E4), a third value (E3), a fourth value (E1) and a fifth value (E5), each one of the first three values (E2, E4, E3) exceeding the fourth and fifth values (E1, E5) taken individually.

EP 0 240 400 B1

10. An optical waveguide made of semiconductor materials according to claim 9, characterized in that the three firstmentioned values (E2, E4, E3) are equal.

11. An optical waveguide made of semiconductor materials according to claim 9, characterized in that the two last-mentioned values (E1 and E5) are equal.

12. An optical waveguide made of semiconductor materials according to claim 6, in which the strip-shaped optical waveguide element (5) strip is parallel to the plane xOy and parallel to the direction Ox, characterized in that the optical waveguide element (5) has a width (w) in the direction Oy such that, in consideration of the refraction indices of the different layers (1, 2, 3, 5) and of the waveguide element (5), as well as in consideration of their thickness, the obtained waveguide is a monomode guide as well in the direction Oy as in the direction Oz perpendicular to the plane xOy for a wave propagating along the direction Ox.

13. An optical waveguide made of semiconductor materials according to claim 6, in which the strip-shaped optical waveguide element (5) is parallel to the plane xOy and parallel to the direction Ox, characterized in that the optical waveguide element (5) has a width (w) along the direction Oy such that, in consideration of the refraction indices of the different layers (1, 2, 3, 5) and of the waveguide element (5) as well as in consideration of their thickness, the obtained waveguide is a bimode waveguide for a wave propagating along the direction Ox.

14. An optical waveguide made of semiconductor materials according to claim 1, characterized in that the waveguide element (5) has a thickness which is smaller than one hundredth of the operational wavelength of the waveguide, such that it constitutes a quantum well in order to increase the energy of the absorption threshold of the material and to consequently reduce the losses of the waveguide.

15. An optical waveguide made of semiconductor materials according to claim 14, characterized in that the fourth and the fifth values (E1, E5) of the widths of forbidden bands in the optical waveguide layer (1) and the optical waveguide element (5) are equal.

16. An optical waveguide made of semiconductor materials according to any one of the preceding claims, characterized in that the optical waveguide element (5) comprises, parallelly to the plane xOy,
– a predetermined number n of optical waveguide sublayers (5.1 to 5.n), each made of a material having an index which exceeds the third index (n3) of the upper optical confinement layer (3),
– these different optical waveguide sub-layers being separated from one another by chemical attack stop sublayers (4.2 to 4.n) each having a thickness which is notably smaller than the operational wavelength (λ) of the waveguide.

17. An optical waveguide made of semiconductor materials according to claim 16, characterized in that each optical wave guide sublayer (5.1 to 5.n) and each chemical attack stop sublayer (4.2 to 4.n) have thicknesses and widths of the forbidden band such as defined for the optical waveguide element (5) and for the chemical attack stop layer (4) in any one of the claims 8, 9 and 10 to 14.

18. An optical waveguide made of semiconductor materials according to claim 16, characterized in that the different optical waveguide sublayers (5.1 to 5.n) are mutually identical and that the different chemical attack stop sublayers (4.2 to 4.n) are identical to the chemical attack stop layer (4).

19. An optical waveguide made of semiconductor materials according to any one of the preceding claims, characterized in that it comprises several optical waveguide elements (5a to 5d) on the chemical attack stop layer (4).

20. An optical waveguide made of semiconductor materials according to any one of the preceding claims, characterized in that each layer (1, 2, 3, 4) and the optical waveguide elements (5) are made of semiconductor materials.

21. An optical waveguide made of semiconductor materials according to claim 20, characterized in that the employed semiconductor materials are members of the groups III and V of the Periodical System of Elements.

22. An optical waveguide made of semiconductor materials according to claim 21, characterized in that the mesh parameter of each layer is adapted to a multiple or a submultiple of the 35 mesh parameters of the adjacent layers.

23. An optical waveguide made of semiconductor materials according to claim 21, characterized in that the lower and upper optical confinement layers (2, 3), the chemical attack stop layer (4) and the chemical attack stop sublayers (4.2 to 4.n) are binary compositions.

24. An optical waveguide made of semiconductor materials according to claim 21, characterized in that the optical waveguide layer (1) and the optical waveguide sublayers (5.1 to 5.n) are ternary or quaternary compositions.

25. An optical waveguide made of semiconductor materials according to claim 23, characterized in that the optical confinement layers (2, 3) as well as the chemical attack stop layers and sublayers (4, 4.2 to 4.n) are made of the same material.

26. An optical waveguide made of semiconductor materials according to claim 24, characterized in that the optical waveguide layer (5) and the optical waveguide sublayers (5.1 to 5.n) are made of the same material.

27. An optical waveguide made of semiconductor materials according to claim 25, characterized in that the optical confinement layers (2 and 3) and the chemical attack stop layers and sublayers (4, 4.2 to 4.n) are made of indium phosphide (InP).

28. An optical waveguide made of a semiconductor material according to claim 26, characterized in that the optical waveguide layer (5) and the optical waveguide sublayers (5.1 to 5.n) are made of gallium-indium-arsenide (InGaAs) or of gallium-indium-arsenide-phosphide (InGaAsP).

29. An optical waveguide made of semiconductor materials according to claim 20, characterized in that the lower optical confinement layer (2) comprises a substrate layer (21) which is $n^+$-doped, and a buffer layer (20) which is $n^-$-doped, the latter being in contact with the optical waveguide layer (1), whereas the upper confinement layer (3) comprises a buffer layer which is $n^-$-doped and which is contact with the chemical attack stop layer (4) and the optical waveguide element (5).

30. A semiconductor laser comprising the waveguide according to any one of the preceding claims, wherein:
– said lower optical confinement layer (2) comprises a substrate (21) made of a semiconductor material of a given doping type (n) whose mesh parameter and forbidden band width present given values,
– said optical waveguide layer (1), which serves as an active zone, is made of a semiconductor material whose mesh parameter is adapted to a multiple or a submultiple of that of the lower optical confinement layer (2) and whose width of the forbidden band is below that of the lower optical confinement layer,
– said chemical attack stop layer (4) presents a mesh parameter adapted to a multiple or a submultiple of that of the optical waveguide layer (1),
– said upper optical confinement layer (3) is made of a semi- conductor material having an opposite doping (p) to that of the lower optical confinement layer (2) and having a mesh parameter adapted to that of the chemical attack stop layer (4) and a width of the forbidden band which exceeds that of the optical waveguide layer (1) and of the optical waveguide element (5),
– and wherein at least two electrodes (6) are applied to the waveguide.

31. A semiconductor laser according to claim 30, characterized in that between the substrate (21) and the optical waveguide layer (1), the lower optical confinement layer (2) further comprises a buffer layer (20) made of the same material as the substrate (21), which however is of a lowe doping rate.

32. A method for manufacturing a waveguide made of semiconductor materials or a semiconductor laser using such a waveguide, said method including the following steps:
a) in a first step, there is realised, on a substrate made of semiconductor material and covered by an optical confinement layer (2), a layer of waveguide material (1) whose mesh parameter is adapted to that of the material of the optical confinement layer (2) and whose width of the forbidden band is below that of the material of the confinement layer,
b) in a second step, there is realised, on the optical waveguide layer (1), a chemical attack stop layer (4) made of a material whose mesh parameter is adapted to that of the material of the optical waveguide layer (1),
c) in a third step, there is realised, on the chemical attack stop layer (4), a layer of an optical waveguide material (50) whose mesh parameter is adapted to that of the material of the chemical attack stop layer(4),,
d) in a foruth step, the layer of optical waveguide material (50) is etched by means of a product which has no action on the chemical attack stop layer (4) such that at least one optical waveguide element (5) in the shape of a strip of a predetermined width is realised,
e) in a fifth step, there is realised on the strip (5) and on the chemical attack stop layer (4), which is not covered by the strip, an upper optical confinement layer (3) made of a semiconductor material whose mesh parameter is adapted to those of the optical waveguide element (5) and of the chemical attack stop layer (4) and whose width of the energy band is larger than that of the optical waveguide element (5) and of the optical waveguide layer (1).

33. A method according to claim 32, characterized in that the steps of realising the layers (1, 4, 5, 3) make use of an epitaxy process.

34. A method according to claim 33, characterized in that the epitaxy process is a vapour phase epitaxy process.

35. A method according to claim 32, characterized in that the thickness of the chemical attack stop layer (4) is substantially smaller than the operational wavelength of the waveguide.

36. A method according to claim 32, characterized in that, on the one hand, the materials used for the realisation of the substrate (2), of the optical confinement layer (3) and of the chemical attack stop layer (4) are identical and that, on the other hand, the materials used for the realisation of the layers of waveguide material (1, 50) are identical.

37. A method according to claim 32, characterized in that
– the third step comprises an alternating succession of phases in which sublayers of optical waveguide materials (5.1 to 5.n) are realised, and phases in which sublayers for stopping the chemical attack (4.2 to 4.n) are realised,
– the fourth step comprises an alternating succession of chemical etching phases allowing to attack the sublayers of waveguide material (5.1 to 5.n), and of etching phases allowing to attack the chemical attack stop sublayers (4.2 to 4.n).

38. A method according to claim 37, characterized in that
– the sublayers of optical waveguide material (5.1 to 5.n) are all of the same material,

EP 0 240 400 B1

– the chemical attack stop sublayers (4.2 to 4.n) are all of the same material as the chemical attack stop layer (4),
– the chemical etching phases allowing to etch the sublayers of waveguide material (5.1 to 5.n) are all of a first type,
– the chemical etching phases allowing to etch the chemical attack stop sublayers are all of a second type,
– the different chemical etching phases are counted in order to avoid that the chemical attack stop layer (4) is etched during a chemical etching phase of the second type.

17

# FIG_1

# FIG_2

# FIG_3

# FIG_4

# FIG_5

# FIG_6

# FIG_7

# FIG_8

FIG_9

EP 0 240 400 B1

# FIG_10

1

20 } 2
21

# FIG_11

4

1

20 } 2
21

# FIG_12

50
4

1

20

} 2

21

# FIG_13

5

4

1

20

} 2

21

# FIG_14

# FIG_15

# FIG_16

4.n

5.n

5.2

4.2

5.1

4

1

20

2

21

# FIG_17

4.n

5.n

4.3

5.2

4.2

5.1

4

1

20

2

21

# FIG_19

3

5.d     5.c     5.b     5.a

4

1

2

FIG_18

Pt                                                          ~6
GaInAs    P⁺    10¹⁹ cm⁻³                                   ~32

$n_3 = 3.16$          InP p          $2.10^{18}$ cm⁻³

$e_3$
$e_4 = 100\text{Å}$          $e_5 = 100\text{Å}$          5
                                                           4
$e_1$          $n_1 = 3.38$          Q=InGaAsP
                                     ($Eg = 1.3\mu m$)      1
$e_2$          $n_{20} = 3.17$          InP n              ~20

$n_{21} = 3.16$          Substrat.          InP n⁺          ~21

EP 0 240 400 B1